(19) Europäisches Patentamt / European Patent Office / Office européen des brevets

(11) **EP 3 410 531 B1**

(12) **EUROPÄISCHE PATENTSCHRIFT**

(45) Veröffentlichungstag und Bekanntmachung des Hinweises auf die Patenterteilung:
**03.07.2024 Patentblatt 2024/27**

(21) Anmeldenummer: **18170300.0**

(22) Anmeldetag: **02.05.2018**

(51) Internationale Patentklassifikation (IPC):
*H01M 10/48* (2006.01)    *H01M 10/42* (2006.01)
*H01M 50/569* (2021.01)    *G01R 31/52* (2020.01)
*G01R 31/40* (2020.01)

(52) Gemeinsame Patentklassifikation (CPC):
**H01M 10/4285; G01R 31/52; H01M 10/48; H01M 50/569;** G01R 31/40; H01M 10/482; Y02E 10/50; Y02E 60/10

(54) **VERFAHREN UND MESSANORDNUNG ZUR ÜBERWACHUNG EINES FERTIGUNGSABLAUFS EINER MODULAR AUFGEBAUTEN SPANNUNGSQUELLE**

METHOD AND MEASURING ARRANGEMENT FOR MONITORING A MANUFACTURING PROCESS OF A MODULAR VOLTAGE SOURCE

PROCÉDÉ ET DISPOSITIF DE MESURE PERMETTANT DE SURVEILLER UN PROCESSUS DE PRODUCTION D'UNE SOURCE DE TENSION DE CONSTRUCTION MODULAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.05.2017 DE 102017209243**

(43) Veröffentlichungstag der Anmeldung:
**05.12.2018 Patentblatt 2018/49**

(73) Patentinhaber: **Bender GmbH & Co. KG
35305 Grünberg (DE)**

(72) Erfinder:
• **SCHÄFER, Oliver
35305 Grünberg (DE)**

• **MACHT, Burkhard
35410 Hungen (DE)**
• **MEHLING, Frank
63691 Ranstadt (DE)**
• **KREUDER, Steffen
35305 Grünberg (DE)**

(74) Vertreter: **advotec.
Patent- und Rechtsanwaltspartnerschaft
Tappe mbB
Georg-Schlosser-Straße 6
35390 Gießen (DE)**

(56) Entgegenhaltungen:
EP-A1- 2 978 063    DE-A1-102013 013 950
DE-A1-102014 003 325    DE-A1-102014 003 910
DE-A1-102014 101 728

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren und eine Messanordnung zur Überwachung eines Fertigungsablaufs einer Spannungsquelle, welche aus in Reihe geschalteten Modulen mit einem elektrisch leitfähigen Gehäuse besteht, wobei die Module während des Fertigungsablaufs von einem ersten Anschluss ausgehend zu einem ersten Modul-Teilstrang und von einem zweiten Anschluss ausgehend zu einem zweiten Modul-Teilstrang schrittweise aufgebaut werden und ein abschließend montiertes Modul beide Modul-Teilstränge miteinander zu einem geschlossenen Modulstrang verbindet.

Im Zuge der Erschließung regenerativer Energiequellen rücken zunehmend Fragestellungen in den Vordergrund, die eine rationelle Fertigung von elektrischen Speichermedien und Spannungsquellen, insbesondere von Hochvolt-Batterien (HV-Batterien) für Elektrofahrzeuge oder von Modulsträngen für Fotovoltaik-Anlagen (PV-Anlagen), betreffen.

Als Anwendungsbeispiel eines der Erfindung zugrundeliegenden Fertigungsprozesses sei zunächst der Montageablauf von HV-Batterien und von Fotovoltaik-Modulsträngen beschrieben.

HV-Batterien für Elektrofahrzeuge bestehen aus einzelnen Batteriemodulen, die während der Fertigung automatisiert in Reihe geschaltet werden, um die erforderliche HV-Spannung zu erreichen.

Zumeist werden dabei die HV-Batterien während des Fertigungsablaufs durch Hinzufügen von Modulen ausgehend von einem ersten Anschluss (Pluspol HV+) zu einem ersten Modul-Teilstrang und von einem zweiten Anschluss (Minuspol HV-) ausgehend zu einem zweiten Modul-Teilstrang schrittweise aufgebaut, wobei ein abschließend montiertes Modul beide Modul-Teilstränge miteinander zu einem geschlossenen Modulstrang verbindet. Erst mit der Montage des abschließend montierten Batteriemoduls ist somit zwischen dem Plus- und Minuspol eine Spannung messbar. Diese Spannung sollte bei fehlerfreier Fertigung der gewünschten Nennspannung (Nominalspannung) der Spannungsquelle entsprechen.

Im Vergleich zu einer einsträngigen Montage treten bei diesem Fertigungsablauf geringere Spannungen und kürzere Montagezeiten auf, da zwei Modul-Teilstränge gleichzeitig aufgebaut werden können.

Eine weitere Anwendung eines zweisträngigen Fertigungsablaufs stellt die Errichtung von Fotovoltaikanlagen dar, wobei einzelne Solarmodule in Reihe geschaltet werden, um letztendlich einen Modulstrang (String) zu bilden. Da ein zentraler Anschlusspunkt an einem Wechselrichter oder an einem Unterverteiler existiert, werden zumeist auch hier die Module jeweils vom Pluspol und vom Minuspol ausgehend in zwei offenen Teilsträngen aufgebaut.

Erst mit der Montage des letzten Moduls wird die Reihenschaltung geschlossen und die gewünschte Nennspannung liegt zwischen dem Plus- und Minuspol an. Solange die Module nicht an den Wechselrichter angeschlossen sind, bilden die (Teil-)Stränge jeweils ein unabhängiges ungeerdetes Stromversorgungssystem. Ein derartiges, ungeerdetes Stromversorgungssystem wird auch als isoliertes Netz (IT-Netz - frz. Isolé Terre) bezeichnet.

Sowohl bei der Fertigung der HV-Batterien, als auch bei der Errichtung von Fotovoltaik-Anlagen und im allgemeinen Fall bei der Produktion von modular aufgebauten Spannungsquellen ergeben sich bei dem beschriebenen Fertigungsablauf daher stets zwei getrennte ungeerdete Teil-Systeme, die erst mit der Montage des letzten, abschließend montierten Moduls zu einem einzigen ungeerdeten Gesamtsystem verbunden werden, das die gewünschte Nennspannung an den Anschlussklemmen bereitstellt.

Während des Fertigungsprozesses können aufgrund mechanischer Verspannungen oder durch äußere Einwirkungen Isolationsfehler an einzelnen Modulen oder Leitungsdefekte (Leitungsbruch) an den elektrischen Verbindungen auftreten, die zu erheblichen Qualitätseinbußen oder zur Unbrauchbarkeit der gesamten Produktionseinheit führen. Auch der Verbau anfänglich defekter Module stellt eine Fehlerquelle dar. Diese Fehler sollten möglichst frühzeitig im Verlauf des Fertigungsprozesses erkannt und lokalisiert werden, da eine Fehlersuche am Ende des Montageprozesses mit einem erheblichem Zeit- und Kostenaufwand verbunden ist.

Zwar ist in vielen Anwendungsfällen an der fertig montierten Spannungsquelle (HV-Batterie oder Fotovoltaikanlage) im späteren Betrieb eine ständige Isolationsüberwachung normativ vorgeschrieben, während der Fertigung hingegen ist eine solche Überwachung nicht vorgesehen.

Bekannt ist, dass beim Aufbau von HV-Batterien per optischer Prozesskontrolle und Verwendung von Robotern versucht wird, den Produktionsprozess so zu optimieren, dass die Ausfallraten so gering wie möglich sind. Erst am Ende des Fertigungsablaufs wird die HV-Spannung überprüft und der Isolationswiderstand gemessen.

Bei dem Aufbau von Fotovoltaikanlagen werden bauartbedingt kurzschlussfeste Kabel mit verpolungssicheren Steckern oder standarisierte Montagesets verwendet. Transportschäden oder Montagefehler mit Auswirkungen auf elektrische Parameter werden erst nach Anschluss des Wechselrichters erkannt. Die Fehlersuche gestaltet sich dann je nach Aufstellort und Größe der Fotovoltaikanlage sehr schwierig.

Die Offenlegungsschrift DE 20 2013 013 950 A1 beschreibt ein Verfahren, eine Messanordnung und ein Messgerät zur Bestimmung von Isolationswiderständen von Einzelzellen einer Hochvoltbatterie während der sequentiellen Montage von Einzelzellen. Dabei wird mittels Spannungsmessungen durch Anlegen von Quellspannungen, die in Amplitude und Frequenz variieren, der Real- und Imaginärteil eines komplexwertigen Isolationswiderstands für jede Einzelzelle bestimmt. Durch eine hinreichende Anzahl von Messungen mit unterschiedlichen Spannungsformen entsteht ein Gleichungssystem aus Knoten- und Maschengleichungen, um für jede Einzelzelle den komplexwertigen Isolationswiderstand berechnen zu können.

Weiter ist aus dem Stand der Technik gemäß der DE 10 2014 003 325 A1 ein Messverfahren und eine Montageeinrichtung zur Isolationsprüfung während der Montage einer aus mehreren Batteriemodulen aufgebauten Hochvollbatterie bekannt. Beim Verbinden der elektrischen Anschlüsse zwischen den Batteriemodulen der Hochvollbatterie wird ein dazu verwendetes elektrisch leitendes Montagewerkzeug an eine den Isolationswiderstand überprüfende Messeinrichtung angeschlossen.

Der· gemessene Isolationswiderstandswert wird mit einem Referenzwert verglichen, und bei einer festgestellten unzulässig großen Differenz zwischen Referenzwert und Isolationswiderstandswert wird ein Fehlersignal auslöst.

Aus der Offenlegungsschrift DE 10 2014 003 910 A1 ist eine Prüfvorrichtung zum gleichzeitigen Prüfen mehrerer Batteriezellen bekannt, wobei die Prüfvorrichtung eine Messvorrichtung zum Erfassen eines Leckstroms, einer Serienspannung, eines Durchgangsstroms und/oder eines weiteren Batterieparameters aufweist. Dazu umfasst die Prüfvorrichtung ein Anschlussnetzwerk, das mehrere Kontaktierungselemente zur elektrischen Kontaktierung mit Polen der Batteriezellen sowie mindestens eine Strombrücke zum elektrischen Verbinden von Batteriezellen aufweist.

Allerdings erweisen sich auch diese bekannten Verfahren hinsichtlich der frühzeitigen Erkennbarkeit von Montagefehlern oft als unzureichend.

Der vorliegenden Erfindung liegt somit die Aufgabe zu Grunde, ein Verfahren und eine Vorrichtung vorzuschlagen, die es ermöglichen, bei einer modular aufgebauten Spannungsquelle während des Herstellungsprozesses auftretende Isolationsfehler und Leitungsdefekte möglichst frühzeitig zu erkennen.

Diese Aufgabe wird erfindungsgemäß durch ein Verfahren nach Anspruch 1 gelöst.

Ausgehend davon, dass bei der Fertigung der Spannungsquelle die Module während des Fertigungsablaufs von einem ersten Anschluss ausgehend zu einem ersten Modul-Teilstrang und von einem zweiten Anschluss ausgehend zu einem zweiten Modul-Teilstrang schrittweise aufgebaut werden, wird ein erster Ankopplungszweig einer Ankopplungsschaltung eines Isolationsüberwachungsgerätes mit dem ersten Anschluss des ersten Modul-Teilstranges, ein zweiter Ankopplungszweig der Ankopplungsschaltung des Isolationsüberwachungsgerätes mit dem zweiten Anschluss des zweiten Modul-Teilstranges und ein Erdungsanschlusses des Isolationsüberwachungsgerätes mit dem Gehäuse der Spannungsquelle verbunden.

Das elektrisch leitfähige Gehäuse dient dabei als Massebezugspunkt wie beispielsweise bei einer Batterie, oder kann, beispielsweise als Modulrahmen ausgebildet, als Bezugspunkt für das Erdpotential bei einer Fotovoltaik-Anlage dienen.

Mit einem in dem Isolationsüberwachungsgerät angeordneten Signalgenerator erfolgt ein Einspeisen eines Messsignals sowohl zwischen dem ersten Anschluss und dem Erdungsanschluss als auch zwischen dem zweiten Anschluss und dem Erdungsanschluss. Das Messsignal ist bevorzugt als Wechselspannungs-Messsignal mit einer bestimmten Messsignalfrequenz ausgeführt.

Jedes Batterie-Modul oder Fotovoltaik-Modul weist einen Ableitwiderstand und eine Ableitkapazität vom Plus- und Minuspol zum Gehäuse auf. Die jeweiligen Größen des Ableitwiderstands (Isolationswiderstand) und der Ableitkapazität werden durch den konstruktiven Aufbau und die verwendeten Materialen der einzelnen Module bestimmt und bewegen sich im hohen Mega- bis Giga-Ohm-Bereich bzw. im einstelligen Nano-Farad-Bereich. Die Ableitwiderstände legen auch die Selbstentladung und die Wirkverluste des Moduls fest.

Die Funktion des Isolationsüberwachungsgerätes kann somit vorteilhaft genutzt werden, um bereits während des Fertigungsablaufs der Spannungsquelle synchron zu dem Montagefortschritt elektrische Kenngrößen wie den Ableitwiderstand und die Ableitkapazität für beide Modul-Teilstränge zu bestimmen.

Dazu erfolgen eine Erfassung und Bestimmung einer ersten Modul-Teilspannung an dem ersten Anschluss nach jedem Hinzufügen eines Moduls zu dem ersten Modul-Teilstrang und eine Erfassung und Bestimmung einer zweiten Modul-Teilspannung an dem zweiten Anschluss nach jedem Hinzufügen eines Moduls zu dem zweiten Modul-Teilstrang.

Sobald ein Modul hinzugefügt wurde, werden unter Verwendung der gemessenen ersten oder zweiten Modul-Teilspannung für den durch das neu hinzugefügte Modul erweiterten Modul-Teilstrang ein Ableitwiderstand und eine Ableitkapazität ermittelt.

Bei jedem Hinzufügen eines Moduls wird die Reihenschaltung, also der Teilstrang der Module um ein neues Modul erweitert, so dass der aktuell ermittelte Ableitwiderstand jedes Teilstrangs - damit auch der Gesamtableitwiderstand der Spannungsquelle - kleiner wird, da neue Ableitwiderstände parallel zu den vorhandenen Ableitwiderständen entstehen. Analog dazu steigt die aktuell ermittelte Ableitkapazität jedes Teilstrangs - damit auch die Gesamtableitkapazität der Spannungsquelle - bei Hinzufügen eines neuen Moduls.

In fehlerfreiem Fall sollten demnach mit Fortschreiten der Fertigung (Hinzufügen neuer Module) ein abnehmender Verlauf des jeweils aktuell ermittelten Ableitwiderstands und ein steigender Verlauf der aktuell ermittelten Ableitkapazität beobachtbar sein.

Auf der Grundlage der ermittelten Ableitwiderstände erfolgt ein Signalisieren eines Isolationsfehlers, falls der Ableitwiderstand nach Hinzufügen eines Moduls unter einen für die fortschreitenden Montagezustände jeweils vorgegebenen Ableitwiderstands-Grenzwert gesunken ist.

In diesem ersten Fehlerfall nimmt der ermittelte Ableitwiderstand zwar erwartungsgemäß nach Hinzufügen eines Moduls ab, unterschreitet dabei aber einen vorgegebenen Ableitwiderstands-Grenzwert. Man kann somit davon ausgehen, dass bei der Montage des zuletzt hinzugefügten Moduls ein Isolationsfehler durch eine unbeabsichtigte elektrische Verbindung gegen das Gehäuse vorliegt, beispielsweise in Form eines Körper- oder Erdschlusses, oder dass das hinzugefügte Modul selbst fehlerhaft ist.

Weiterhin erfolgt ein Signalisieren einer Leitungsunterbrechung, falls sich der Ableitwiderstand durch Hinzufügen eines Moduls nicht verringert und/oder falls sich die Ableitkapazität durch Hinzufügen des Moduls nicht vergrößert hat.

In diesem zweiten Fehlerfall sinkt der aktuell ermittelte Ableitwiderstand und steigt die Ableitkapazität nach der Montage eines weiteren Moduls nicht wie erwartet, sodass davon auszugehen ist, dass die Modulanschlussleitungen fehlerhaft sind, beispielsweise eine Leitungsunterbrechung aufweisen.

Nach jedem Hinzufügen eines weiteren Moduls erfolgt eine Prüfung, ob eine Fehlerspannung zwischen dem ersten Anschluss und dem zweiten Anschluss messbar ist.

Da die beiden Modul-Teilstränge zwei offene Teil-Systeme bilden, sollte keine Spannung zwischen dem ersten Anschluss und dem zweiten Anschluss messbar sein, solange die Modul-Teilstränge nicht durch das abschließend montierte Modul zu einem Gesamtsystem verbunden sind. Erst nach Montage des abschließenden Moduls steht eine Spannung in Höhe der Nominalspannung zwischen dem ersten Anschluss und dem zweiten Anschluss zur Verfügung.

Ist bereits während des Hinzufügens eines weiteren Moduls eine Spannung zwischen dem ersten Anschluss und dem zweiten Anschluss messbar, so kann diese als Fehlerspannung interpretiert werden, die auf eine unbeabsichtigte, leitende Verbindung zwischen beiden Modul-Teilsträngen und damit auf einen Fehler in Form eines "Crossfaults" hindeutet.

Bliebe ein derartiger "Crossfault" unentdeckt, so würde sich bei Hinzufügen des abschließenden Moduls ein Kurzschlussstrom einstellen, der eine erhebliche Schädigung der Spannungsquelle nach sich ziehen könnte.

Nach dem Hinzufügen des abschließend montierten Moduls erfolgt eine Prüfung, ob sich eine Nominalspannung zwischen dem ersten Anschluss und dem zweiten Anschluss einstellt.

Ist nach der Montage aller Module die gewünschte Nominalspannung messbar, so kann davon ausgegangen werden, dass alle montierten Module die erforderliche Spannung bereitstellen und keine "Crossfaults" aufgetreten sind - der Fertigungsprozess somit fehlerfrei verlaufen ist.

Das erfindungsgemäße Verfahren stellt somit vorteilhafterweise sicher, dass ein Leitungsbruch, ein Isolationsfehler und ein "Crossfault" bereits während des Fertigungsprozesses der Spannungsquelle erkannt und lokalisiert werden.

In weiterer Ausgestaltung wird eine Ermittlung einer Gesamt-Ableitimpedanz der Spannungsquelle durchgeführt.

Aus der Kenntnis der für jeden Modul-Teilstrang ermittelten Ableitwiderstände und Ableitkapazitäten ist es zweckmäßig, eine für die Spannungsquelle geltende Gesamt-Ableitimpedanz zu berechnen. Die berechnete Gesamt-Ableitimpedanz stellt eine komplexwertige Größe dar, deren Realteil einem Gesamt-Isolationsfehlerwiderstand und deren Imaginärteil einer Gesamt-Ableitkapazität entspricht.

Weiterhin wird zur Erkennung eines fehlerhaften Moduls eine Modulspannung berechnet, wobei sich die Modulspannung aus der Modul-Teilspannung und einem aus dem Ableitwiderstand und Ankoppel- und Messwiderständen des Isolationsüberwachungsgerätes gebildeten Spannungsteiler ergibt.

Vorteilhafterweise erfolgt die Erkennung des fehlerhaften Moduls in dem Modul-Teilstrang und/oder in dem geschlossenen Modulstrang.

Tritt während der Montage der Module ein Isolationsfehler auf, so entspricht der ermittelte Ableitwiderstand einem Isolationsfehlerwiderstand. Der Stromkreis schließt sich über den Isolationsfehlerwiderstand und bildet mit den bekannten Ankoppel- und Messwiderständen des Isolationsüberwachungsgerätes einen Spannungsteiler. Aus diesen Widerständen lässt sich mit der gemessenen Modul-Teilspannung eine Modulspannung berechnen, welche über den zwischen dem ersten/zweiten Anschluss und dem Isolationsfehlerort montierten Modulen anliegt. Die berechnete Modulspannung ist damit gleich oder größer der Summe der von intakten Modulen zwischen dem erstem/zweiten Anschluss und dem Isolationsfehlerort erzeugten Spannung. Daraus kann in Kenntnis einer für jedes Modul spezifizierten Modul-Nennspannung die Anzahl fehlerfrei montierter Module zwischen dem erstem/zweiten Anschluss und dem Isolationsfehlerort bestimmt werden, woraus sich der Ort eines fehlerhaften Moduls in dem offenen Modul Teilstrang ermitteln lässt. Es kann also beispielsweise bei einem erkannten Isolationsfehler festgestellt werden, dass dieser Isolationsfehler an dem n-ten montierten Modul aufgetreten ist, falls die berechnete Modulspannung die (n-1) Modul-Nennspannungen der davor liegenden Module umfasst.

Ebenso ermöglicht die Berechnung der Modulspannung in dem geschlossenen Modulstrang ein montiertes fehlerhaftes Modul zu identifizieren, also einen Fehlerort in dem geschlossenen Modulstrang zu bestimmen. Dieses Vorgehen erweist sich als vorteilhaft, da durch mechanische Bearbeitungsschritte nicht nur an dem gerade hinzugefügten Modul, sondern auch an zuvor montierten Modulen Fehler auftreten können.

Mit Vorteil erfolgen bei einer Spannungsquelle, welche einen ersten Messanschluss und einen zweiten Messanschluss aufweist, während der Montage eine Anschlussüberwachung der Verbindung des ersten Ankopplungszweigs mit dem ersten Anschluss, eine Anschlussüberwachung der Verbindung des zweiten Ankopplungszweigs mit dem zweiten Anschluss und eine Anschlussüberwachung der Verbindung des Erdungsanschlusses des Isolationsüberwachungsgerätes mit dem Gehäuse der Spannungsquelle.

In dem weitgehend automatisierten Fertigungsprozess muss sichergestellt sein, dass das Isolationsüberwachungsgerät mit der Spannungsquelle ordnungsgemäß verbunden ist. Dies kann mittels einer Anschlussüberwachung des ersten und zweiten Anschlusses sowie des Gehäuses (Masse- bzw. Erdpotential) sichergestellt werden.

Weiterhin erfolgen die Anschlussüberwachung der Verbindung des ersten Ankopplungszweigs mit dem ersten Anschluss und die Anschlussüberwachung des zweiten Ankopplungszweigs mit dem zweiten Anschluss jeweils mit einer Leiterschleife.

Die Leiterschleife führt ausgehend von dem Erdungsanschluss des Isolationsüberwachungsgerätes über den ersten/zweiten Messanschluss der Spannungsquelle und über den ersten/zweiten Anschluss der Spannungsquelle zurück zu dem ersten/zweiten Ankopplungszweig des Isolationsüberwachungsgerätes. Ein in der Leiterschleife fließender Strom erwarteter Größe signalisiert eine intakte Verbindung des zu überwachenden ersten/zweiten Anschlusses.

Vorzugsweise erfolgt eine Messung einer definierten Endgliedkapazität oder einer definierten Endgliedimpedanz in der jeweiligen Leiterschleife.

Bei dieser Ausgestaltung wird zwischen dem Erdungsanschluss des Isolationsüberwachungsgerätes und dem ersten/zweiten Messanschluss der Spannungsquelle jeweils eine definierte Endgliedkapazität bekannter Größe oder eine definierte Endgliedimpedanz bekannter Größe in die jeweilige Leiterschleife eingefügt und mit dem Isolationsüberwachungsgerät gemessen.

Stimmt die gemessene Endgliedkapazität/Endgliedimpedanz mit dem bekannten Wert der definierten Endgliedkapazität/Endgliedimpedanz überein, so kann von einer ordnungsgemäßen Verbindung der der Verbindung des ersten/zweiten Ankopplungszweigs des Isolationsüberwachungsgerätes mit dem ersten/zweiten Anschluss der Spannungsquelle ausgegangen werden.

Statt der komplexwertigen Endgliedimpedanz kann nur die Endgliedkapazität (Imaginärteil der Endgliedimpedanz) eingefügt und gemessen werden - mit dem Vorteil, dass kein Entladestrom über einen Endgliedwiderstand (Realteil der Endgliedimpedanz) fließen kann.

Weiterhin erfolgt die Anschlussüberwachung der Verbindung des Erdungsanschlusses mit dem Gehäuse der Spannungsquelle durch eine Leiterschleife, wobei die Leiterschleife mit dem Erdungsanschluss und mit einem parallel zu dem Erdungsanschluss ausgeführten Zusatz-Erdungsanschluss des Isolationsüberwachungsgerätes verbunden wird.

Aus dem Stand der Technik bekannte Isolationsüberwachungsgeräte weisen einen parallel zu dem Erdungsanschluss ausgeführten Zusatz-Erdungsanschluss auf. Ausgehend von dem Erdungsanschluss des Isolationsüberwachungsgerätes wird eine über das Gehäuse der Spannungsquelle geschlossene Leiterschleife zurück zu dem Zusatz-Erdungsanschluss gebildet, mit der die Durchgängigkeit der Verbindung des Erdungsanschlusses geprüft werden kann.

In einer weiteren Ausgestaltung kann das Verfahren zur Überwachung von mehr als zwei Modul-Teilsträngen Anwendung finden.

Das erfindungsgemäße Verfahren ist nicht auf die Überwachung von genau zwei Modul-Teilsträngen beschränkt. Eine Erweiterung durch weitere parallel ausgeführte Signalpfade mit Ankopplung an weitere Modul-Teilstränge sowie der Bestimmung weiterer Ableitimpedanzen ist zweckmäßig.

Die der Erfindung zugrunde liegende Aufgabe wird weiterhin durch eine erfindungsgemäße Messanordnung nach Anspruch 11 gelöst.

Die erfindungsgemäße Messanordnung umfasst sämtliche strukturellen Merkmale um das erfindungsgemäße Verfahren zur Überwachung eines Fertigungsablaufs einer Spannungsquelle mit den dargelegten vorteilhaften Wirkungen auszuführen.

In Umsetzung des erfindungsgemäßen Verfahrens weist die Messanordnung ein Isolationsüberwachungsgerät mit einer Ankopplungsschaltung auf, deren erster Ankopplungszweig zum Erfassen einer ersten Modul-Teilspannung mit dem ersten Anschluss verbunden ist, ein zweiter Ankopplungszweig der Ankopplungsschaltung zum Erfassen einer zweiten Modul-Teilspannung mit dem zweiten Anschluss verbunden ist.

Das Isolationsüberwachungsgerät weist ferner einen Signalgenerator zum Einspeisen eines Messsignals und eine Spannungsmessschaltung auf, wobei der Signalgenerator mit der Ankopplungsschaltung in Reihe geschaltet ist und ein Erdungsanschluss des Signalgenerators mit dem Gehäuse der Spannungsquelle verbunden ist und wobei die Spannungsmessschaltung zum Bestimmen der ersten Modul-Teilspannung und der zweiten Modul-Teilspannung eingangsseitig mit der Ankopplungsschaltung und ausgangsseitig über einen Analog-Digital-Umsetzer mit einer digitalen Recheneinheit verbunden ist.

Die digitale Recheneinheit ist ausgelegt zum Ermitteln eines Ableitwiderstands und einer Ableitkapazität für den ersten und den zweiten Modul-Teilstrang nach jedem Hinzufügen eines Moduls, zum Signalisieren eines Isolationsfehlers, falls der Ableitwiderstand nach Hinzufügen eines Moduls unter einen vorgegebenen Ableitwiderstands-Grenzwert gesunken ist und zum Signalisieren einer Leitungsunterbrechung, falls sich der Ableitwiderstand durch Hinzufügen eines Moduls nicht verringert hat oder falls sich die Ableitkapazität durch Hinzufügen eines Moduls nicht vergrößert hat. Ferner ist die digitale Recheneinheit ausgelegt zum Prüfen, ob eine Fehlerspannung und eine Nominalspannung zwischen dem ersten Anschluss und dem zweiten Anschluss messbar sind.

In weiteren Ausgestaltungen ist die digitale Recheneinheit ausgelegt zur Ermittlung einer Gesamt-Ableitimpedanz der Spannungsquelle sowie zur Berechnung einer Modulspannung, um ein fehlerhaftes Modul in dem Modul-Teilstrang und/oder in dem geschlossenen Modulstrang zu erkennen.

Alternativ oder ergänzend zu der rechnerischen Ermittlung der komplexwertigen Gesamt-Ableitimpedanz in der digitalen Recheneinheit weist das Isolationsüberwachungsgerät eine Impedanzmessschaltung zur Ermittlung einer komplexwertigen Gesamt-Ableitimpedanz der Spannungsquelle auf, deren Realteil einem Gesamt-Isolationsfehlerwiderstand und deren Imaginärteil einer Gesamt-Ableitkapazität entspricht.

Mit Vorteil ist bei einer Spannungsquelle, welche einen ersten Messanschluss und einen zweiten Messanschluss aufweist, jeweils eine Leiterschleife zur Anschlussüberwachung der Verbindung des ersten Ankopplungszweigs mit dem ersten Anschluss, zur Anschlussüberwachung der Verbindung des zweiten Ankopplungszweigs mit dem zweiten Anschluss und zur Anschlussüberwachung der Verbindung des Erdungsanschlusses des Isolationsüberwachungsgerätes mit dem Gehäuse der Spannungsquelle ausgebildet.

Die Errichtung von Leiterschleifen, die jeweils einen geschlossenen Stromkreis mit Einbindung des zu überwachenden Anschlusses bilden, ermöglicht die Prüfung, ob das Isolationsüberwachungsgerät ordnungsgemäß mit der Spannungsquelle verbunden ist.

Vorzugsweise ist dabei die Leiterschleife zur Anschlussüberwachung der Verbindung des ersten/zweiten Ankopplungszweigs mit dem ersten/zweiten Anschluss ausgehend von dem Erdungsanschluss des Isolationsüberwachungsgerätes über den ersten/zweiten Messanschluss der Spannungsquelle und über den ersten/zweiten Anschluss der Spannungsquelle zurück zu dem ersten/zweiten Ankopplungszweig des Isolationsüberwachungsgerätes geführt.

Bevorzugt weist die jeweilige Leiterschleife zur Anschlussüberwachung der Verbindung des ersten/zweiten Ankopplungszweigs mit dem ersten/zweiten Anschluss definierte Endgliedkapazitäten oder definierte Endgliedimpedanzen zwischen dem Erdungsanschluss des Isolationsüberwachungsgerätes und dem ersten/zweiten Messanschluss der Spannungsquelle auf.

Der Wert der definierten Endgliedkapazitäten oder der definierten Endgliedimpedanzen wird von dem Isolationsüberwachungsgerät gemessen und mit dem bekannten (Soll-)Wert verglichen. Im Falle einer Nicht-Übereinstimmung ist von einem Anschlussfehler auszugehen.

Weiterhin ist die Leiterschleife zur Anschlussüberwachung der Verbindung des Erdungsanschlusses des Isolationsüberwachungsgerätes mit dem Gehäuse der Spannungsquelle ausgehend von dem Erdungsanschluss des Isolationsüberwachungsgerätes über das Gehäuse der Spannungsquelle zurück zu einem parallel zu dem Erdungsanschluss ausgeführten Zusatz-Erdungsanschluss des Isolationsüberwachungsgerätes geführt.

Diese so ausgebildete Leiterschleife dient der Überprüfung des Gehäuseanschlusses und geht davon aus, dass das Isolationsüberwachungsgerät dem Stand der Technik gemäß einen parallel zu dem Erdungsanschluss ausgeführten Zusatz-Erdungsanschluss aufweist.

Als zweckmäßig erweisen sich weitere parallel ausgeführte Ankopplungszweige zur Überwachung von mehr als zwei Modul-Teilsträngen, wobei die Spannungsmessschaltung und die digitale Recheneinheit zur Bestimmung und Auswertung weiterer Ableitimpedanzen (Ableitwiderstände und Ableitkapazitäten) ausgelegt sind.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:

**Fig. 1:** eine Spannungsquelle mit zwei Modul-Teilsträngen

**Fig. 2:** ein vereinfachtes Schaltbild eines Moduls der Spannungsquelle,

**Fig. 3:** eine schematische Darstellung einer erfindungsgemäßen Messanordnung mit Spannungsquelle und Isolationsüberwachungsgerät,

**Fig. 4:** ein Ersatzschaltbild zur Ermittlung einer Modulspannung und

**Fig. 5:** eine Messanordnung mit Endgliedimpedanzen zur Anschlussüberwachung.

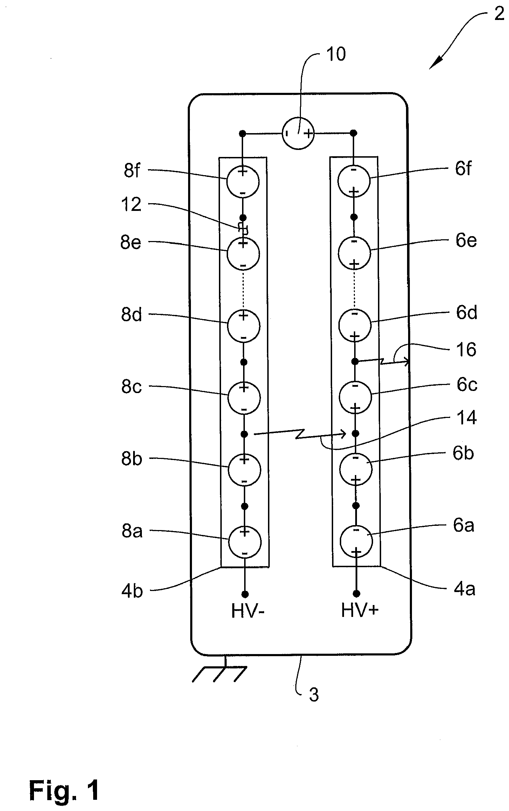

In **Fig. 1** sei an dem Beispiel einer modular aufgebauten HV-Batterie zunächst der Fertigungsablauf erläutert, der einer Anwendung des erfindungsgemäßen Verfahrens und der erfindungsgemäßen Messanordnung zugrunde liegt.

Die HV-Batterie ist als Spannungsquelle 2 bestehend aus in zwei Modul-Teilsträngen 4a, 4b angeordneten Modulen 6a bis 6f, 8a bis 8f, 10 zusammen mit einem Gehäuse 3 dargestellt. Grundsätzlich kann bei der Anwendung des Verfahrens eine beliebige Anzahl von Modulen 6a bis 6f, 8a bis 8f, 10 zu ersten und zweiten Modul-Teilsträngen 4a, 4b aufgebaut werden, wobei sich auch der erste und der zweite Teilstrang 4a, 4b in der Anzahl der Module unterscheiden können, sofern dies technisch sinnvoll und praktikabel erscheint. Insoweit umfasst die Erfindung auch einen unsymmetrischen Aufbau der beiden Modul-Teilstränge 4a, 4b sowie einen Aufbau, bei dem lediglich ein Modul-Teilstrang (4a, 4b) errichtet wird.

Während des Fertigungsprozesses der Spannungsquelle 2 werden die einzelnen Module 6a bis 6f, 8a bis 8f ausgehend von einem ersten Anschluss HV+ und ausgehend von einem zweiten Anschluss HV- schrittweise aufgebaut. An das erste Modul 6a des ersten Modul-Teilstrangs 4a wird das zweite Modul 6b und an das erste Modul 8a des zweiten Modul-Teilstrangs 4b das zweite Modul 8b angeschlossen, anschließend wird das dritte Modulpaar 6c, 8c hinzugefügt, usw. Es entstehen zwei getrennte, "wachsende" Modul-Teilstränge 4a und 4b, die jeweils ein ungeerdetes (Stromversorgungs-)System bilden.

Nach dem Hinzufügen des Modulpaares 6f, 8f werden die beiden offenen Modul-Teilstränge 4a, 4b durch Hinzufügen des abschließend montierten Moduls 10 zu einem geschlossenen Modulstrang verbunden. Erst danach ist eine Spannung zwischen dem ersten Anschluss HV+ und dem zweiten Anschluss HV- abgreifbar. Bei fehlerfreier Funktion und Montage der Module 6a bis 6f, 8a bis 8f, 10 entspricht diese Spannung der Nominalspannung der Spannungsquelle 2.

Weiterhin sind in Fig. 1 als mögliche Fehlerquellen ein Leitungsbruch 12 zwischen den in Reihe geschalteten Modulen 6a bis 6f, 8a bis 8f, 10, ein "Crossfault" 14 zwischen den Modul-Teilsträngen 4a, 4b sowie ein Isolationsfehler 16 zwischen den Modulen 6a bis 6f, 8a bis 8f, 10 und dem Gehäuse 3 dargestellt.

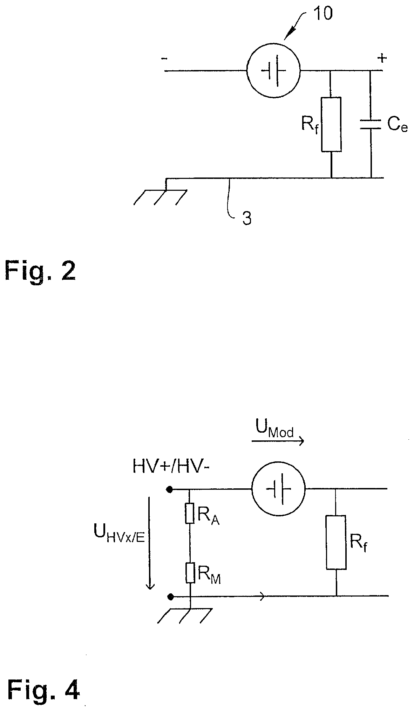

**Fig. 2** zeigt stellvertretend für die montierten Module 6a bis 6f, 8a bis 8f, 10 ein vereinfachtes Schaltbild des Moduls 10 der Spannungsquelle 2. Das Modul 10 weist einen Ableitwiderstand $R_f$ und eine Ableitkapazität $C_e$ gegen das Gehäuse 3 auf.

Aufgrund der Reihenschaltung der Module 6a bis 6f, 8a bis 8f, 10 entstehen nach jedem Hinzufügen eines weiteren Moduls 6b bis 6f, 8b bis 8f, 10 weitere parallele Ableitpfade zu dem Gehäuse 3 (Fig. 1), sodass der aktuell - nach dem Hinzufügen eines weiteren Moduls 6b bis 6f, 8b bis 8f, 10 - ermittelte Ableitwiderstand abnimmt und die aktuell ermittelte Ableitkapazität zunimmt.

Indem der aktuell ermittelte Ableitwiderstand und die aktuell ermittelte Ableitkapazität erfindungsgemäß zur Überwachung der Fertigungsqualität herangezogen und ausgewertet werden, können mögliche Isolationsfehler und Leitungsdefekte (Leitungsbrüche und "Crossfaults") bereits während des Fertigungsablaufs frühzeitig erkannt werden.

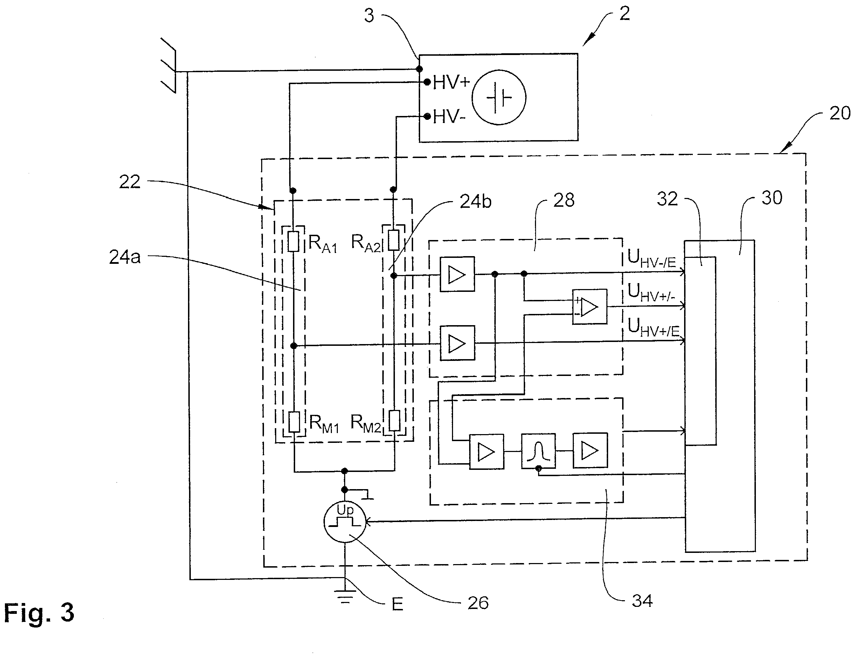

Die **Fig.3** zeigt eine schematische Darstellung einer erfindungsgemäßen Messanordnung mit der Spannungsquelle 2, an die ein Isolationsüberwachungsgerät 20 angeschlossen ist.

Das Isolationsüberwachungsgerät 20 umfasst eine Ankopplungsschaltung 22 mit einem ersten und einem zweiten Ankopplungszweig 24a, 24b mit Ankoppelwiderständen $R_{A1}$, $R_{A2}$ und Messwiderständen $R_{M1}$, $R_{M2}$, einen zu der Ankopplungsschaltung 22 in Reihe geschalteten Signalgenerator 26 zum Einspeisen eines Messsignal $U_p$, eine Spannungsmessschaltung 28 sowie eine digitale Recheneinheit 30 mit Analog-Digital-Umsetzer 32.

Optional kann das Isolationsüberwachungsgerät 20 eine Impedanzmessschaltung 34 zur Ermittlung einer Gesamt-Ableitimpedanz der Spannungsquelle 2 aufweisen.

Der erste Ankopplungszweig 24a ist an den ersten Anschluss HV+ der Spannungsquelle 2, der zweite Ankopplungszweig 24b an den zweiten Anschluss HV- der Spannungsquelle 2 angeschlossen. Ein Erdungsanschluss E des Isolationsüberwachungsgerätes 20 ist mit dem Gehäuse 3 der Spannungsquelle 2 verbunden.

Die an dem ersten und dem zweiten Anschluss HV+, HV- anliegenden Modul-Teilspannungen $U_{HV+/E}$, $U_{HV-/E}$ werden mittels Ankopplungsschaltung 22 erfasst, in der Spannungsmessschaltung 28 bestimmt und über den Analog-Digital-Umsetzer 32 der digitalen Recheneinheit 30 zugeführt. Dort werden mit Verfahren der digitalen Signalverarbeitung (Filterung) die Modul-Teilspannungen $U_{HV+/E}$, $U_{HV-/E}$ zur Ermittlung des Ableitwiderstands $R_f$ und der Ableitkapazität $C_e$ herangezogen.

Darüber hinaus kann die Spannungsmessschaltung 28 einen Differenzverstärker 29 zur Ermittlung einer Differenzspannung $U_{HV+/-}$ aus den beiden Modul-Teilspannungen $U_{HV+/E}$, $U_{HV-/E}$ aufweisen. Die Differenzspannung $U_{HV+/-}$ wird ebenfalls über den Analog-Digital-Umsetzer 32 an die digitale Recheneinheit 30 weitergeleitet.

**Fig. 4** zeigt ein Ersatzschaltbild zur Ermittlung einer Modulspannung $U_{Mod}$ aus der jeweils ermittelten Modul-Teilspannung $U_{HV+/E}$, $U_{HV-/E}$ ($U_{HVx/E}$) und dem ermittelten Ableitwiderstand $R_f$ (Isolationsfehler) sowie aus bekannten Ankoppel- und Messwiderständen $R_A$, $R_M$ des Isolationsüberwachungsgerätes 20. Der Ableitwiderstand $R_f$ bildet mit den Ankoppel- und Messwiderständen $R_A$, $R_M$ einen Spannungsteiler, demgemäß eine Modulspannung $U_{Mod}$ berechnet werden kann, welche über den zwischen dem ersten/zweiten Anschluss HV+/HV- und dem Isolationsfehlerort montierten Modulen anliegt:

$$U_{Mod} = U_{HVx/E} * [1 + R_f / (R_A + R_M)].$$

In gleicher Weise kann bei geschlossenem Modulstrang für eines oder mehrere der Module 6a bis 6f, 8a bis 8f, 10 eine Modulspannung $U_{Mod}$ ermittelt werden, sodass sowohl bei offenem Modul-Teilstrang 4a, 4b als auch bei geschlossenem Modulstrang durch einen Vergleich der berechneten Modulspannung mit einer spezifizierten Modul-Nennspannung eine Fehlerorterkennung, d.h. die Identifizierung eines fehlerhaften Moduls möglich ist.

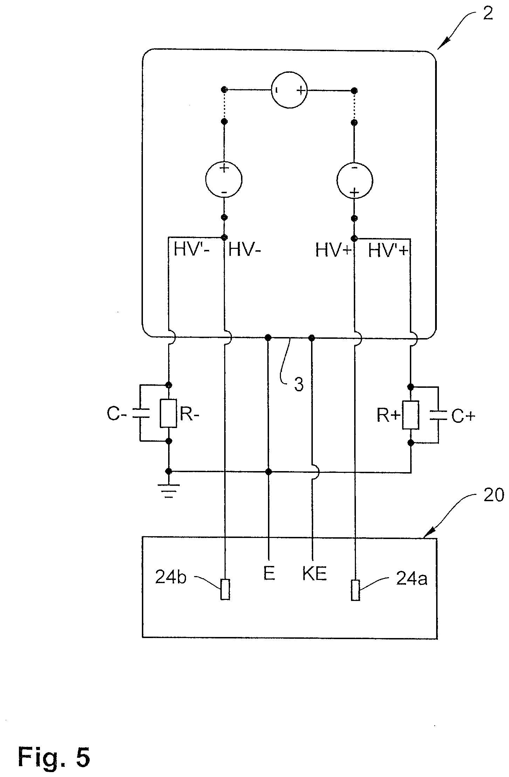

**Fig. 5** zeigt eine Messanordnung mit Endgliedimpedanzen C+, R+; C-, R-zur Anschlussüberwachung des ersten/zweiten Anschlusses HV+/ HVsowie des Anschlusses des Gehäuses 3 der Spannungsquelle 2 an das Isolationsüberwachungsgerät 20.

Die Spannungsquelle 2 weist neben dem ersten/zweiten Anschluss HV+/HV-, der mit dem ersten/zweiten Ankopplungszweig 24a/24b verbunden ist, einen ersten/zweiten Messanschluss HV'+/HV'- auf. Zwischen dem ersten/zweiten Messanschluss HV'+/HV'- und dem Erdungsanschluss E des Isolationsüberwachungsgerätes 20 ist jeweils eine definierte Endgliedimpedanz C+, R+; C-, R- bekannter Größe geschaltet.

Es bildet sich somit für die Überwachung des ersten/zweiten Anschlusses HV+/HV- jeweils eine Leiterschleife aus, die ausgehend von dem Erdungsanschluss E des Isolationsüberwachungsgerätes 20 über die jeweilige Endgliedimpedanz C+, R+ bzw. C-, R-, über den ersten/zweiten Messanschluss HV'+/HV'- der Spannungsquelle 2 und über den ersten/zweiten Anschluss HV+/HV- der Spannungsquelle 2 zurück zu dem ersten/zweiten Ankopplungszweig 24a/24b des Isolationsüberwachungsgerätes 20 führt.

Zur Überwachung der Verbindung des Erdungsanschlusses E des Isolationsüberwachungsgerätes 20 mit dem Gehäuse 3 der Spannungsquelle 2 wird ein parallel zu dem Erdungsanschluss E ausgeführter Zusatz-Erdungsanschluss KE des Isolationsüberwachungsgerätes 20 verwendet, so dass sich eine Leiterschleife ausbilden kann, die ausgehend von dem Erdungsanschluss E über das Gehäuse 3 zurück zu dem Zusatz-Erdungsanschluss KE führt.

## Patentansprüche

1.   Verfahren zur Überwachung eines Fertigungsablaufs einer Spannungsquelle (2), welche aus in Reihe geschalteten Modulen (6a bis 6f, 8a bis 8f, 10) mit einem elektrisch leitfähigen Gehäuse (3) besteht, wobei die Module während des Fertigungsablaufs von einem ersten Anschluss (HV+) ausgehend zu einem ersten Modul-Teilstrang (4a) und von einem zweiten Anschluss (HV-) ausgehend zu einem zweiten Modul-Teilstrang (4b) schrittweise aufgebaut werden und ein abschließend montiertes Modul (10) beide Modul-Teilstränge (4a, 4b) miteinander zu einem geschlossenen Modulstrang verbindet, umfassend die Verfahrensschritte:

Verbinden eines ersten Ankopplungszweigs (24a) einer Ankopplungsschaltung (22) eines Isolationsüberwachungsgerätes (20) mit dem ersten Anschluss (HV+), Verbinden eines zweiten Ankopplungszweigs (24b) der Ankopplungsschaltung (22) des Isolationsüberwachungsgerätes (20) mit dem zweiten Anschluss (HV-) und Verbinden eines Erdungsanschlusses (E) des Isolationsüberwachungsgerätes (20) mit dem Gehäuse (3) der Spannungsquelle (2),
Einspeisen eines Messsignals ($U_P$) zwischen dem ersten Anschluss (HV+) und dem Erdungsanschluss (E) und zwischen dem zweiten Anschluss (HV-) und dem Erdungsanschluss (E),
nach jedem Hinzufügen eines Moduls zu dem ersten Modul-Teilstrang (4a) Erfassen und Bestimmen einer ersten Modul-Teilspannung ($U_{HV+/E}$) an dem ersten Anschluss (HV+),
nach jedem Hinzufügen eines Moduls zu dem zweiten Modul-Teilstrang (4b) Erfassen und Bestimmen einer zweiten Modul-Teilspannung ($U_{HV-/E}$) an dem zweiten Anschluss (HV-),
nach jedem Hinzufügen eines Moduls Ermitteln eines Ableitwiderstands ($R_f$) und Ermitteln einer Ableitkapazität ($C_e$) für den Modul-Teilstrang (4a, 4b), zu dem das Modul hinzugefügt wurde,
Signalisieren eines Isolationsfehlers (16), falls der Ableitwiderstand ($R_f$) durch Hinzufügen des Moduls unter einen vorgegebenen Ableitwiderstands-Grenzwert gesunken ist,
Signalisieren einer Leitungsunterbrechung (12), falls sich der Ableitwiderstand ($R_f$) durch Hinzufügen des Moduls nicht verringert hat,
Signalisieren einer Leitungsunterbrechung (12), falls sich die Ableitkapazität ($C_e$) durch Hinzufügen des Moduls nicht vergrößert hat,
nach jedem Hinzufügen eines Moduls Prüfen, ob eine Spannung als Fehlerspannung zwischen dem ersten Anschluss (HV+) und dem zweiten Anschluss (HV-) messbar ist,
nach dem Hinzufügen des abschließend montierten Moduls (10) Prüfen, ob sich eine Nominalspannung zwischen dem ersten Anschluss (HV+) und dem zweiten Anschluss (HV-) einstellt.

2.   Verfahren nach Anspruch 1,
**dadurch gekennzeichnet,**
**dass** eine Ermittlung einer Gesamt-Ableitimpedanz der Spannungsquelle (2) durchgeführt wird.

**3.** Verfahren nach Anspruch 1 oder 2,
**dadurch gekennzeichnet,**
**dass** zur Erkennung eines fehlerhaften Moduls eine Modulspannung ($U_{Mod}$) berechnet wird, wobei sich die Modulspannung ($U_{Mod}$) aus der Modul-Teilspannung ($U_{HV+/E}$, $U_{HV-/E}$) und einem aus dem Ableitwiderstand ($R_f$) und Ankoppel- und Messwiderständen ($R_A$, $R_M$) des Isolationsüberwachungsgerätes (20) gebildeten Spannungsteiler ergibt.

**4.** Verfahren nach Anspruch 3,
**dadurch gekennzeichnet,**
**dass** die Erkennung des fehlerhaften Moduls in dem Modul-Teilstrang (4a, 4b) erfolgt.

**5.** Verfahren nach Anspruch 3 oder 4,
**dadurch gekennzeichnet,**
**dass** die Erkennung des fehlerhaften Moduls in dem geschlossenen Modulstrang erfolgt.

**6.** Verfahren nach einem der Ansprüche 1 bis 5,
**dadurch gekennzeichnet,**
**dass** bei einer Spannungsquelle (2), welche einen ersten Messanschluss (HV'+) und einen zweiten Messanschluss (HV'-) aufweist, eine Anschlussüberwachung der Verbindung des ersten Ankopplungszweigs(24a) mit dem ersten Anschluss (HV+), eine Anschlussüberwachung der Verbindung des zweiten Ankopplungszweigs (24b) mit dem zweiten Anschluss (HV-) und eine Anschlussüberwachung der Verbindung des Erdungsanschlusses (E) des Isolationsüberwachungsgerätes (20) mit dem Gehäuse (3) der Spannungsquelle (2) erfolgen.

**7.** Verfahren nach Anspruch 6,
**dadurch gekennzeichnet,**
**dass** die Anschlussüberwachung der Verbindung des ersten Ankopplungszweigs (24a) mit dem ersten Anschluss (HV+) und die Anschlussüberwachung des zweiten Ankopplungszweigs (24b) mit dem zweiten Anschluss (HV-) jeweils mit einer Leiterschleife erfolgen.

**8.** Verfahren nach Anspruch 7,
**dadurch gekennzeichnet,**
**dass** eine Messung einer definierten Endgliedkapazität ($C_+$, $C_-$) oder einer definierten Endgliedimpedanz ($C_+$, $R_+$; $C_-$, $R_-$) in der jeweiligen Leiterschleife erfolgt.

**9.** Verfahren nach einem der Ansprüche 6 bis 8,
**dadurch gekennzeichnet,**
**dass** die Anschlussüberwachung der Verbindung des Erdungsanschlusses (E) mit dem Gehäuse (3) der Spannungsquelle (2) durch eine Leiterschleife erfolgt, wobei die Leiterschleife mit dem Erdungsanschluss (E) und mit einem parallel zu dem Erdungsanschluss (E) ausgeführten Zusatz-Erdungsanschluss (KE) des Isolationsüberwachungsgerätes (20) verbunden wird.

**10.** Verfahren nach einem der Ansprüche 1 bis 9,
**gekennzeichnet durch**
eine Anwendung des Verfahrens zur Überwachung von mehr als zwei Modul-Teilsträngen.

**11.** 11. Messanordnung zur Überwachung eines Fertigungsablaufs einer Spannungsquelle (2), welche aus in Reihe geschalteten Modulen (6a bis 6f, 8a bis 8f, 10) mit einem elektrisch leitfähigen Gehäuse (3) besteht, wobei die Module während des Fertigungsablaufs von einem ersten Anschluss (HV+) ausgehend zu einem ersten Modul-Teilstrang (4a) und von einem zweiten Anschluss (HV-) ausgehend zu einem zweiten Modul-Teilstrang (4b) schrittweise aufgebaut werden und ein abschließend montiertes Modul (10) beide Modul-Teilstränge (4a, 4b) miteinander zu einem geschlossenen Modulstrang verbindet,
mit einem Isolationsüberwachungsgerät (20), welches aufweist: eine Ankopplungsschaltung (22), wobei ein erster Ankopplungszweig (24a) der Ankopplungsschaltung (22) zum Erfassen einer ersten Modul-Teilspannung ($U_{HV+/E}$) mit dem ersten Anschluss (HV+) verbunden ist, ein zweiter Ankopplungszweig (24b) der Ankopplungsschaltung (22) zum Erfassen einer zweiten Modul-Teilspannung ($U_{HV-/E}$) mit dem zweiten Anschluss (HV-) verbunden ist, einen Signalgenerator (26) zum Einspeisen eines Messsignals ($U_P$), wobei der Signalgenerator (26) mit der Ankopplungsschaltung (22) in Reihe geschaltet ist und ein Erdungsanschluss (E) des Signalgenerators (26) mit dem Gehäuse (3) der Spannungsquelle (2) verbunden ist, eine Spannungsmessschaltung (28), wobei die Spannungsmessschaltung (14) zum Bestimmen der ersten Modul-Teilspannung ($U_{HV+/E}$) und der zweiten Modul-Teilspannung ($U_{HV-/E}$) eingangsseitig mit der Ankopplungsschaltung (22) und ausgangsseitig über einen Analog-Digital-Umsetzer (32) mit einer digitalen Recheneinheit (30) verbunden ist, die ausgelegt ist zum Ermitteln eines Ableitwiderstands ($R_f$) und einer Ableitkapazität ($C_e$) für den ersten und den zweiten Modul-Teilstrang (4a, 4b) nach jedem Hinzufügen eines Moduls, zum Signalisieren eines Isolationsfehlers (16), falls der Ableitwiderstand ($R_f$) durch Hinzufügen eines Moduls unter einen vorgegebenen Ableitwiderstands-Grenzwert gesunken ist und zum Signalisieren einer Leitungsunterbrechung (12), falls sich der Ableitwiderstand ($R_f$) durch Hinzufügen eines Moduls nicht verringert hat oder falls sich die Ableitkapazität ($C_e$) durch Hinzufügen eines Moduls nicht vergrößert hat und die ausgelegt ist zum Prüfen, ob eine Spannung als Fehlerspannung und eine Nominalspannung zwischen dem ersten Anschluss (HV+) und dem zweiten Anschluss (HV-) messbar sind.

12. Messanordnung nach Anspruch 11,
**dadurch gekennzeichnet,**
**dass** die digitale Recheneinheit (30) zur Ermittlung einer Gesamt-Ableitimpedanz der Spannungsquelle (2) ausgelegt ist.

13. Messanordnung nach Anspruch 11 oder 12,
**dadurch gekennzeichnet,**
**dass** das Isolationsüberwachungsgerät (20) eine Impedanzmessschaltung (34) zur Ermittlung einer Gesamt-Ableitimpedanz der Spannungsquelle (2) aufweist.

14. Messanordnung nach einem der Ansprüche 11 bis 13,
**dadurch gekennzeichnet,**
**dass** die digitale Recheneinheit (30) zur Berechnung einer Modulspannung ($U_{Mod}$) ausgelegt ist, um ein fehlerhaftes Modul in dem Modul-Teilstrang (4a, 4b) und/oder in dem geschlossenen Modulstrang zu erkennen.

15. Messanordnung nach einem der Ansprüche 11 bis 14,
**dadurch gekennzeichnet,**
**dass** bei einer Spannungsquelle (2), welche einen ersten Messanschluss (HV'+) und einen zweiten Messanschluss (HV'-) aufweist, jeweils eine Leiterschleife zur Anschlussüberwachung der Verbindung des ersten Ankopplungszweigs (24a) mit dem ersten Anschluss (HV+), zur Anschlussüberwachung der Verbindung des zweiten Ankopplungszweigs (24b) mit dem zweiten Anschluss (HV-) und zur Anschlussüberwachung der Verbindung des Erdungsanschlusses (E) des Isolationsüberwachungsgerätes (20) mit dem Gehäuse (3) der Spannungsquelle (2) ausgebildet ist.

16. Messanordnung nach Anspruch 15,
**dadurch gekennzeichnet,**
**dass** die Leiterschleife zur Anschlussüberwachung der Verbindung des ersten/zweiten Ankopplungszweigs (24a, 24b) mit dem ersten/zweiten Anschluss (HV+, HV-) ausgehend von dem Erdungsanschluss (E) des Isolationsüberwachungsgerätes (20) über den ersten/zweiten Messanschluss (HV'+, HV'-) der Spannungsquelle (2) und über den ersten/zweiten Anschluss der Spannungsquelle (2) zurück zu dem ersten/zweiten Ankopplungszweig (24a, 24b) des Isolationsüberwachungsgerätes (20) geführt ist.

17. Messanordnung nach Anspruch 16,
**dadurch gekennzeichnet,**
**dass** die jeweilige Leiterschleife zur Anschlussüberwachung der Verbindung des ersten/zweiten Ankopplungszweigs (24a, 24b) mit dem ersten/zweiten Anschluss (HV+, HV-) definierte Endgliedkapazitäten ($C_+$, $C_-$) oder definierte Endgliedimpedanzen ($C_+$, R+; $C_-$, $R_-$) zwischen dem Erdungsanschluss (E) des Isolationsüberwachungsgerätes und dem ersten/zweiten Messanschluss (HV'+, HV'-) der Spannungsquelle (2) aufweist.

18. Messanordnung nach einem der Ansprüche 11 bis 17,
**dadurch gekennzeichnet,**
**dass** die Leiterschleife zur Anschlussüberwachung der Verbindung des Erdungsanschlusses (E) des Isolationsüberwachungsgerätes (20) mit dem Gehäuse (3) der Spannungsquelle (2) ausgehend von dem Erdungsanschluss (E) des Isolationsüberwachungsgerätes (20) über das Gehäuse (3) der Spannungsquelle (2) zurück zu einem parallel zu dem Erdungsanschluss (E) ausgeführten Zusatz-Erdungsanschluss (KE) des Isolationsüberwachungsgerätes (20) geführt ist.

**19.** Messanordnung nach einem der Ansprüche 11 bis 18,
**gekennzeichnet durch**
weitere parallel ausgeführte Ankopplungszweige zur Überwachung von mehr als zwei Modul-Teilsträngen, wobei die Spannungsmessschaltung (28) und die digitale Recheneinheit (30) zur Bestimmung und Auswertung weiterer Ableitimpedanzen ausgelegt sind.

**Claims**

**1.** A method for monitoring a production process of a voltage source (2), which consists of modules (6a to 6f, 8a to 8f, 10) connected in series and having an electrically conductive casing (3), said modules being set up step-by-step during the production process starting from a first connection (HV+) to form a first partial string of the module (4a) and starting from a second connection (HV-) to form a second partial string of the module (4b) and a lastly installed module (10) connecting both partial strings of the modules (4a, 4b) to each other so as to form a closed module string, the method comprising the steps:

- connecting a first coupling branch (24a) of a coupling circuit (22) of an insulation monitoring device (20) to the first connection (HV+), connecting a second coupling branch (24b) of the coupling circuit (22) of the insulation monitoring device (20) to the second connection (HV-), and connecting a ground connection (E) of the insulation monitoring device (20) to the casing (3) of the voltage source (2),
- feeding a measuring signal ($U_P$) between the first connection (HV+) and the ground connection (E) and between the second connection (HV-) and the ground connection (E),
- capturing and determining a first partial voltage of the module ($U_{HV+/E}$) at the first connection (HV+) every time a module has been added to the first partial string of the module (4a),
- capturing and determining a second partial voltage of the module ($U_{HV-/E}$) at the second connection (HV-) every time a module has been added to the second partial string of the module (4b),
- detecting a leakage resistance ($R_f$) every time a module has been added and detecting a leakage capacitance ($C_e$) for the partial string of the module (4a, 4b) to which the module was added,
- signaling an insulation fault (16) should the leakage resistance (Rf) drop below a given leakage resistance threshold value by adding the module,
- signaling a line disruption (12) should the leakage resistance ($R_f$) not have decreased by adding the module,
- signaling a line disruption (12) should the leakage capacitance ($C_e$) not have increased by adding the module,
- testing whether a voltage is measured between the first connection (HV+) and the second connection (HV-) as a fault voltage every time a module has been added,
- testing whether a nominal voltage has been set between the first connection (HV+) and the second connection (HV-) every time the lastly installed module (10) has been added.

**2.** The method according to claim 1,
**characterized in that**
an overall leakage impedance of the voltage source (2) is detected.

**3.** The method according to claim 1 or 2,
**characterized in that**
a module voltage ($U_{Mod}$) is calculated for identifying a faulty module, said module voltage ($U_{Mod}$) being derived from the partial voltage of the module ($U_{HV+/E}$, $U_{HV-/E}$) and from a voltage divider formed by the leakage resistance (Rf) and coupling and measuring resistances ($R_A$, $R_M$) of the insulation monitoring device (20).

**4.** The method according to claim 3,
**characterized in that**
the faulty module is identified in the partial string of the module (4a, 4b).

**5.** The method according to claim 3 or 4,
**characterized in that**
the faulty module is identified in the closed module string.

**6.** The method according to any one of the claims 1 to 5,
**characterized in that**
in a voltage source (2) which comprises a first measuring connection (HV'+) and a second measuring connection (HV'-), the connection between the first coupling branch (24a) and the first connection (HV+) is monitored, the connection between the second coupling branch (24b) and the second connection (HV-) is monitored, and the connection between the ground connection (E) of the insulation monitoring device (20) and the casing (3) of the voltage source (2) is monitored.

7. The method according to claim 6,
**characterized in that**
the connection between the first coupling branch (24a) and the first connection (HV+) and the connection between the second coupling branch (24b) and the second connection (HV-) are each monitored using a conductor loop.

8. The method according to claim 7,
**characterized in that**
a defined terminal element capacitance (C+, C_) or a defined terminal element impedance (C+, R+; C_, R_) is measured in the respective conductor loop.

9. The method according to any one of the claims 6 to 8,
**characterized in that**
the connection between the ground connection (E) and the casing (3) of the voltage source (2) is monitored via a conductor loop, said conductor loop being connected to the ground connection (E) and to an additional ground connection (KE) of the insulation monitoring device (20) carried out parallel to the ground connection (E).

10. The method according to any one of the claims 1 to 9,
**characterized by**
an application of the method for monitoring more than two partial strings of the modules.

11. A measuring arrangement for monitoring a production process of a voltage source (2), which consists of modules (6a to 6f, 8a to 8f, 10) connected in series and having an electrically conductive casing (3), said modules being set up step-by-step during the production process starting from a first connection (HV+) to a first partial string of the module (4a) and starting from a second connection (HV-) to a second partial string of the module (4b) and a lastly installed module (10) connecting both partial strings of the modules (4a, 4b) to each other to form a closed module string, the measuring arrangement having an insulation monitoring device (20), which comprises: a coupling circuit (22), a first coupling branch (24a) of the coupling circuit (22) being connected to the first connection (HV+) for capturing a first partial voltage of the module ($U_{HV+/E}$), a second coupling branch (24b) of the coupling circuit (22) being connected to the second connection (HV-) for capturing a second partial voltage of the module ($U_{HV-/E}$); a signal generator (26) for feeding a measuring signal ($U_P$), said signal generator (26) being connected in series with the coupling circuit (22) and a ground connection (E) of the signal generator (26) being connected to the casing (3) of the voltage source (2); a voltage measuring circuit (28), said voltage measuring circuit (28) being connected to the coupling circuit (22) on the inlet side and to a digital computing unit (30) on the outlet side via a digital-analog converter (32) in order to determine the first partial voltage of the module ($U_{HV+/E}$) and the second partial voltage of the module ($U_{HV-/E}$), said computing unit (30) being configured for detecting a leakage resistance (Rf) and a leakage capacitance ($C_e$) for the first and the second partial string of the module (4a, 4b) every time a module has been added, for signaling an insulation fault (16) should the leakage resistance (Rf) have dropped below a given leakage resistance threshold value by adding a module, and for signaling a line disruption (12) should the leakage resistance (Rf) should not have decreased by adding a module or should the leakage capacitance ($C_e$) should not have increased by adding a module and being configured for testing whether a voltage and a nominal voltage is measured between the first connection (HV+) and the second connection (HV-), the former being measured as a fault voltage.

12. The measuring arrangement according to claim 11,
**characterized in that**
the digital computing unit (30) is configured for detecting an overall leakage impedance of the voltage source (2).

13. The measuring arrangement according to claim 11 or 12,
**characterized in that**
the insulation monitoring device (20) comprises an impedance measuring circuit (34) for detecting an overall leakage impedance of the voltage source (2).

14. The measuring arrangement according to any one of the claims 11 to 13,

**characterized in that**
the digital computing unit (30) is configured for calculating a module voltage ($U_{Mod}$) in order to identify a faulty module in the partial string of the module (4a, 4b) and/or in the closed module string.

15. The measuring arrangement according to any one of the claims 11 to 14,
    **characterized in that**
    in a voltage source (2), which comprises a first measuring connection (HV'+) and a second measuring connection (HV'-), a conductor loop is realized for monitoring the connection between the first coupling branch (24a) and the first connection (HV+), for monitoring the connection between the second coupling branch (24b) and the second connection (HV-), and for monitoring the connection between the ground connection (E) of the insulation monitoring device (20) and the casing (3) of the voltage source (2), respectively.

16. The measuring arrangement according to claim 15,
    **characterized in that**
    in order to monitor the connection between the first/second coupling branch (24a, 24b) and the first/second connection (HV+, HV-), the conductor loop is guided back to the first/second coupling branch (24a, 24b) of the insulation monitoring device (20) via the first/second measuring connection (HV'+, HV'-) of the voltage source (2) and via the first/second connection of the voltage source (2) starting from the ground connection (E) of the insulation monitoring device (20).

17. The measuring arrangement according to claim 16,
    **characterized in that**
    the respective conductor loop for monitoring the connection between the first/second coupling branch (24a, 24b) and the first/second connection (HV+, HV-) comprises defined terminal element capacitances (C+, C_) or defined terminal element impedances (C+, R+; C-, R_) between the ground connection (E) of the insulation monitoring device and the first/second measuring connection (HV'+, HV'-) of the voltage source (2).

18. The measuring arrangement according to any one of the claims 11 to 17,
    **characterized in that**
    the conductor loop for monitoring the connection between the ground connection (E) of the insulation monitoring device (20) and the casing (3) of the voltage source (2) is guided back to an additional ground connection (KE) of the insulation monitoring device (20), which is carried out parallel to the ground connection (E), via the casing (3) of the voltage source (2) starting from the ground connection (E) of the insulation monitoring device (20).

19. The measuring arrangement according to any one of the claims 11 to 18,
    **characterized by**
    further coupling branches, which are carried out parallel, for monitoring more than two partial strings of the modules, the voltage measuring circuit (28) and the digital computing unit (30) being configured for determining and evaluating further leakage impedances.

**Revendications**

1. Procédé pour surveiller un processus de production d'une source de tension (2), qui consiste en modules (6a à 6f, 8a à 8f, 10) reliés en série et ayant un boîtier (3) électriquement conducteur, lesdits modules étant mis en place pas à pas au cours du processus de production à partir d'une première connexion (HV+) pour former une première section de module (4a) et à partir d'une deuxième connexion (HV-) pour former une deuxième section de module (4b) et un module (10) installé en dernier lieu reliant les deux sections de module (4a, 4b) l'une à l'autre de manière à former une section de module fermée, le procédé comprenant les étapes suivantes :

   - la connexion d'une première branche de couplage (24a) d'un circuit de couplage (22) d'un dispositif (20) de surveillance d'isolement à la première connexion (HV+), la connexion d'une deuxième branche de couplage (24b) du circuit de couplage (22) du dispositif (20) de surveillance d'isolement à la deuxième connexion (HV-), et la connexion d'une prise de terre (E) du dispositif (20) de surveillance d'isolement au boîtier (3) de la source de tension (2),
   - l'alimentation en un signal de mesure ($U_P$) entre la première connexion (HV+) et la prise de terre (E) et entre la deuxième connexion (HV-) et la prise de terre (E),
   - le capture et la détermination d'une première partie de la tension ($U_{HV+/E}$) du module au niveau de la première connexion (HV+) chaque fois qu'un module a été ajouté à la première section de module (4a),
- le capture et la détermination d'une deuxième partie de la tension ($U_{HV-/E}$) du module au niveau de la deuxième connexion (HV-) chaque fois qu'un module a été ajouté à la deuxième section de module (4b),
- la détection d'une résistance de fuite (Rf) chaque fois qu'un module a été ajouté et la détection d'une capacité de fuite ($C_e$) pour la section de module (4a, 4b) à laquelle le module a été ajouté,
- la signalisation d'une faute d'isolement (16) si la résistance de fuite (Rf) passe en dessous d'un seuil de résistance de fuite donné par l'ajout du module,
- la signalisation d'une coupure de ligne (12) si la résistance de fuite (Rf) n'a pas diminué par l'ajout du module,
- la signalisation d'une coupure de ligne (12) si la capacité de fuite ($C_e$) n'a pas augmenté par l'ajout du module,
- l'essai si une tension est mesurée comme tension de faute entre la première connexion (HV+) et la deuxième connexion (HV) chaque fois qu'un module a été ajouté,
- l'essai si une tension nominale a été réglée entre la première connexion (HV+) et la deuxième connexion (HV-) chaque fois que le dernier module installé (10) a été ajouté.

2.  Procédé selon la revendication 1,
    **caractérisé en ce**
    **qu'**une impédance de fuite totale de la source de tension (2) est détectée.

3.  Procédé selon la revendication 1 ou la revendication 2,
    **caractérisé en ce**
    **qu'**une tension de module ($U_{Mod}$) est calculée pour identifier un module défectueux, ladite tension de module ($U_{Mod}$) étant dérivée de la tension partielle ($U_{HV+/E}$ , $U_{HV-/E}$) du module et d'un diviseur de tension formé par la résistance de fuite (Rf) et les résistances de couplage et de mesure ($R_A$ , $R_M$) du dispositif (20) de surveillance d'isolement.

4.  Procédé selon la revendication 3,
    **caractérisé en ce que**
    le module défectueux est identifié dans la section de module (4a, 4b).

5.  Procédé selon la revendication 3 ou la revendication 4,
    **caractérisé en ce que**
    le module défectueux est identifié dans la section de module fermée.

6.  Procédé selon l'une quelconque des revendications 1 à 5,
    **caractérisé en ce que**
    dans une source de tension (2) qui comprend une première connexion de mesure (HV'+) et une deuxième connexion de mesure (HV'-), la connexion entre la première branche de couplage (24a) et la première connexion (HV+) est surveillée, la connexion entre la deuxième branche de couplage (24b) et la deuxième connexion (HV-) est surveillée, et la connexion entre la prise de terre (E) du dispositif (20) de surveillance d'isolement et le boîtier (3) de la source de tension (2) est surveillée.

7.  Procédé selon la revendication 6,
    **caractérisé en ce que**
    la connexion entre la première branche de couplage (24a) et la première connexion (HV+) et la connexion entre la deuxième branche de couplage (24b) et la deuxième connexion (HV-) sont chacune surveillées à l'aide d'une boucle de conducteur.

8.  Procédé selon la revendication 7,
    **caractérisé en ce**
    **qu'**une capacité définie (C+ , C_) de l'élément terminal ou une impédance définie (C+ , R+ ; C_ , R_) de l'élément terminal est mesurée dans la boucle de conducteur respective.

9.  Procédé selon l'une quelconque des revendications 6 à 8,
    **caractérisé en ce que**
    la connexion entre la prise de terre (E) et le boîtier (3) de la source de tension (2) est surveillée via une boucle de conducteur, ladite boucle de conducteur étant reliée à la prise de terre (E) et à une prise de terre supplémentaire (KE) réalisée parallèlement à la prise de terre (E) du dispositif (20) de surveillance d'isolement.

10. Procédé selon l'une quelconque des revendications 1 à 9,

**EP 3 410 531 B1**

**caractérisé par**
une application du procédé pour la surveillance de plus de deux sections de module.

11. Agencement de mesure pour surveiller un processus de production d'une source de tension (2), qui consiste en modules (6a à 6f, 8a à 8f, 10) reliés en série et ayant un boîtier (3) électriquement conducteur, lesdits modules étant mis en place pas à pas au cours du processus de production à partir d'une première connexion (HV+) pour former une première section de module (4a) et à partir d'une deuxième connexion (HV-) pour former une deuxième section de module (4b) et un module (10) installé en dernier lieu reliant les deux sections de module (4a, 4b) l'une à l'autre de manière à former une section de module fermée,
l'agencement de mesure ayant un dispositif (20) de surveillance d'isolement, qui comprend : un circuit de couplage (22), une première branche de couplage (24a) du circuit de couplage (22) étant reliée à la première connexion (HV+) pour capturer une première partie de tension (U$_{HV+/E}$) du module, une deuxième branche de couplage (24b) du circuit de couplage (22) étant reliée à la deuxième connexion (HV-) pour capturer une deuxième partie de tension (U$_{HV-/E}$) du module ; un générateur de signal (26) pour alimenter en un signal de mesure (U$_P$), ledit générateur de signal (26) étant relié en série avec le circuit de couplage (22) et une prise de terre (E) du générateur de signal (26) étant reliée au boîtier (3) de la source de tension (2) ; un circuit (28) de mesure de tension, ledit circuit (28) de mesure de tension étant relié au circuit de couplage (22) du côté de l'entrée et à une unité de compte (30) numérique du côté de la sortie via un convertisseur numérique-analogique (32) afin de déterminer la première partie de tension (U$_{HV+/E}$) du module et la deuxième partie de tension (U$_{HV-/E}$) du module, ladite unité de compte (30) étant configurée pour détecter une résistance de fuite (Rf) et une capacité de fuite (C$_e$) pour la première et la deuxième section de module (4a, 4b) chaque fois qu'un module a été ajouté, pour signaler une faute d'isolement (16) si la résistance de fuite (R$_f$) est tombée en dessous d'un seuil donné de résistance de fuite par l'ajout d'un module, et pour signaler une coupure de ligne (12) si la résistance de fuite (Rf) n'a pas diminué par l'ajout d'un module ou si la capacité de fuite (C$_e$) n'a pas augmenté par l'ajout d'un module, et étant configurée pour essayer si une tension et une tension nominale sont mesurées entre la première connexion (HV+) et la seconde connexion (HV-), la première étant mesurée comme une tension de faute.

12. Agencement de mesure selon la revendication 11,
**caractérisé en ce que**
l'unité de compte (30) numérique est configurée pour détecter une impédance de fuite totale de la source de tension (2).

13. Agencement de mesure selon la revendication 11 ou la revendication 12,
**caractérisé en ce que**
le dispositif (20) de surveillance d'isolement comprend un circuit (34) de mesure d'impédance pour détecter une impédance de fuite totale de la source de tension (2).

14. Agencement de mesure selon l'une quelconque des revendications 11 à 13,
**caractérisé en ce que**
l'unité de compte (30) numérique est configurée pour calculer une tension de module (U$_{Mod}$) afin d'identifier un module défectueux dans la section de module (4a, 4b) et/ou dans la section de module fermée.

15. Agencement de mesure selon l'une quelconque des revendications 11 à 14,
**caractérisé en ce que**
dans une source de tension (2), qui comprend une première connexion de mesure (HV'+) et une deuxième connexion de mesure (HV'-), une boucle de conducteur est réalisée pour surveiller la connexion entre la première branche de couplage (24a) et la première connexion (HV+), pour surveiller la connexion entre la deuxième branche de couplage (24b) et la deuxième connexion (HV-), et pour surveiller la connexion entre la prise de terre (E) du dispositif (20) de surveillance d'isolement et le boîtier (3) de la source de tension (2), respectivement.

16. Agencement de mesure selon la revendication 15,
**caractérisé en ce**
**qu'**afin de surveiller la connexion entre la première/deuxième branche de couplage (24a, 24b) et la première/deuxième connexion (HV+, HV-), la boucle de conducteur est reconduite à la première/deuxième branche de couplage (24a, 24b) du dispositif (20) de surveillance d'isolement via la première/deuxième connexion de mesure (HV'+, HV'-) de la source de tension (2) et via la première/seconde connexion de la source de tension (2) à partir de la prise de terre (E) du dispositif (20) de surveillance d'isolement.

**17.** Agencement de mesure selon la revendication 16,
**caractérisé en ce que**
la boucle de conducteur respective pour la surveillance de la connexion entre la première/deuxième branche de couplage (24a, 24b) et la première/deuxième connexion (HV+, HV-) comprend des capacités (C+, C_) définies de l'élément terminal ou des impédances (C+, R+ ; C, R_) définies de l'élément terminal entre la prise de terre (E) du dispositif de surveillance d'isolement et la première/deuxième connexion de mesure (HV'+, HV'-) de la source de tension (2).

**18.** Agencement de mesure selon l'une quelconque des revendications 11 à 17,
**caractérisé en ce que**
la boucle de conducteur pour surveiller la connexion entre la prise de terre (E) du dispositif (20) de surveillance d'isolement et le boîtier (3) de la source de tension (2) est reconduite à une prise de terre (KE) supplémentaire du dispositif (20) de surveillance d'isolement, qui s'effectue parallèlement à la prise de terre (E), via le boîtier (3) de la source de tension (2) à partir de la prise de terre (E) du dispositif (20) de surveillance d'isolement.

**19.** Agencement de mesure selon l'une quelconque des revendications 11 à 18,
**caractérisé par**
d'autres branches de couplage, réalisées en parallèle, pour surveiller plus de deux sections de module, le circuit de mesure de la tension (28) et l'unité de compte (30) numérique étant configurés pour déterminer et évaluer d'autres impédances de fuites.

**Fig. 1**

Fig. 2

Fig. 4

Fig. 3

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 202013013950 A1
- DE 102014003325 A1

- DE 102014003910 A1